# EUROPEAN PATENT APPLICATION

(11) **EP 4 852 620 A1**
(43) Date of publication of application: **09.12.2026**
(21) Application number: 24926671.9
(22) Date of filing: 26.08.2024
(51) Int. Cl.: H05K 1/02

(54) **POWER MODULE, COMMUNICATION DEVICE, ELECTRIC-MOTOR DRIVER, POWER ASSEMBLY, AND VEHICLE**

(30) Priority: 26.02.2024 CN 202410210621
(71) Applicant: HUAWEI TECHNOLOGIES CO., LTD., Shenzhen, Guangdong 518129 (CN)
(72) Inventor: LI, Huan, Shenzhen, Guangdong 518129 (CN); GENG, Yi, Shenzhen, Guangdong 518129 (CN); ZHANG, Xiaojie, Shenzhen, Guangdong 518129 (CN); CHEN, Changhao, Shenzhen, Guangdong 518129 (CN)
(74) Representative: Huawei European IPR
(86) International application number: PCT/CN2024/114478
(87) International publication number: WO 2025/179804

(57) **Abstract**

Embodiments of this application provide a power module, a communication device, a motor controller, a powertrain, and a vehicle. The power module includes an electronic component. The power module can effectively shorten a length of a heat dissipation path of the electronic component, improve heat dissipation efficiency of the electronic component, and ensure that heat generated by the electronic component is dissipated in a timely manner. The power module includes a first base plate, a first heat dissipation pad, and a first electronic component. A second surface is recessed to form a first heat dissipation blind slot. The first heat dissipation pad has a first orthographic projection on a first surface, the first heat dissipation blind slot has a second orthographic projection on the first surface, and the first orthographic projection and the second orthographic projection at least partially overlap.

## Description

This application claims priority to Chinese Patent Application No. 202410210621.6, filed with the China National Intellectual Property Administration on February 26, 2024 and entitled "POWER MODULE, COMMUNICATION DEVICE, MOTOR CONTROLLER, POWERTRAIN, AND VEHICLE", which is incorporated herein by reference in its entirety.

### TECHNICAL FIELD

This application relates to the field of communication technologies, vehicle technologies, and the like, and in particular, to a power module, a communication device, a motor controller, a powertrain, and a vehicle.

### BACKGROUND

With development of fields such as artificial intelligence (artificial intelligence, AI), 5^{th} generation mobile communication technology (5^{th} generation mobile communication technology, 5G), 6^{th} generation mobile communication technology (6^{th} generation mobile communication technology, 6G), and cloud computing, power consumption of power modules is increasing. To ensure reliability of the power modules, a demand for heat dissipation of the power modules is increasingly strong. A power module is a high-frequency electric energy conversion apparatus.

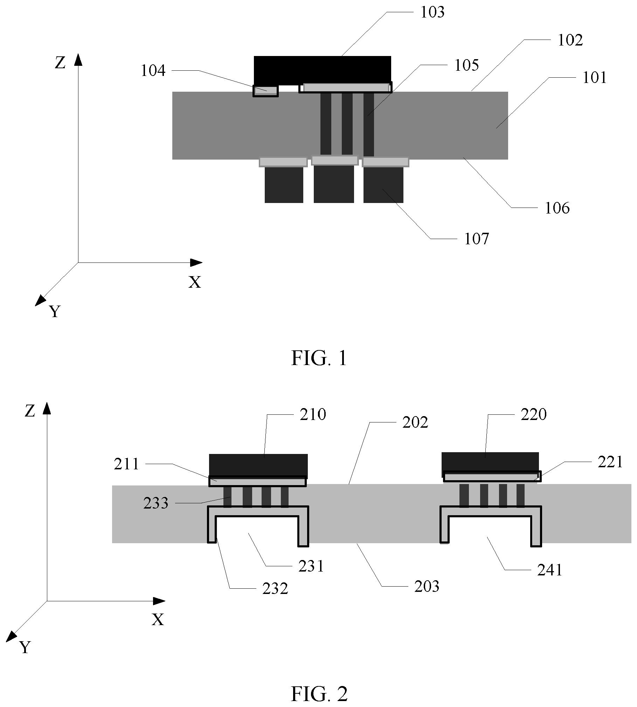

FIG. 1 is an example diagram of a first structure of an existing power module. The power module includes a first base plate 101. An electronic component 103 is soldered to a first surface 102 through a heat dissipation pad 104. A plurality of vias 105 penetrating the entire first base plate 101 in a direction Z are provided. In this case, two ends of the via 105 extend to the first surface 102 and a second surface 106 of the first base plate 101, respectively. The via 105 is filled with resin and electroplated. A plurality of copper blocks 107 are soldered to the second surface 106. Heat generated by the electronic component 103 is transferred to the plurality of copper blocks 107 through the heat dissipation pad 104 and the plurality of vias 105, and the plurality of copper blocks 107 dissipate the heat.

In the direction Z, a heat dissipation path for dissipating heat from the electronic component 103 includes the heat dissipation pad 104, the via 105, and the copper block 107. As a result, the heat dissipation path along the direction Z is long, heat dissipation efficiency is low, and it cannot be ensured that the heat generated by the electronic component 103 is dissipated in a timely manner through the heat dissipation path.

### SUMMARY

Embodiments of this application provide a power module, a communication device, a motor controller, a powertrain, and a vehicle. The power module includes an electronic component. The power module can effectively shorten a length of a heat dissipation path of the electronic component, improve heat dissipation efficiency of the electronic component, and ensure that heat generated by the electronic component is dissipated in a timely manner.

A first aspect of an embodiment of this application provides a power module, including a first base plate, a first heat dissipation pad, and a first electronic component. The first base plate includes a first surface and a second surface that are opposite to each other. The first electronic component is connected to the first surface through the first heat dissipation pad. The second surface is recessed to form a first heat dissipation blind slot. An accommodation cavity of the first heat dissipation blind slot is located inside the first base plate. A slot opening of the first heat dissipation blind slot is located on the second surface of the first base plate, and extends into the first base plate to form the accommodation cavity of the first heat dissipation blind slot. In a direction perpendicular to the first surface, a cavity length of the accommodation cavity is less than a height of the first base plate. The first heat dissipation pad has a first orthographic projection on the first surface. The first heat dissipation blind slot has a second orthographic projection on the first surface. The first orthographic projection at least partially overlaps the second orthographic projection.

According to this aspect, when the first orthographic projection at least partially overlaps the second orthographic projection, it effectively ensures that heat absorbed by the first heat dissipation pad is successfully dissipated by the first heat dissipation blind slot, thereby ensuring successful heat dissipation of the first electronic component. It may be understood that a part of heat generated by the first electronic component is dissipated through the heat dissipation pad, and the other part of the heat is conducted to the first heat dissipation blind slot. The heat is dissipated by the first heat dissipation blind slot, thereby achieving timely heat dissipation of the first electronic component. In addition, the first heat dissipation blind slot is formed by recessing the second surface of the first base plate, thereby effectively shortening a length of a heat dissipation path between the first heat dissipation blind slot and the first electronic component, reducing thermal resistance, and improving heat dissipation efficiency of the first electronic component.

Based on the first aspect, in an optional implementation, the first heat dissipation blind slot has the accommodation cavity, and a cavity wall of the accommodation cavity includes a metal layer. Through this implementation, the cavity wall of the accommodation cavity of the first heat dissipation blind slot includes the metal layer, effectively improving heat dissipation efficiency of the first heat dissipation blind slot.

Based on the first aspect, in an optional implementation, the power module further includes a thermally conductive module. The thermally conductive module is made of a thermally conductive material. The thermally conductive module is located in the accommodation cavity of the first heat dissipation blind slot, and the thermally conductive module is connected to the accommodation cavity. Through this implementation, the heat from the first electronic component is conducted to a first thermally conductive module, so that the first thermally conductive module dissipates the heat, thereby improving heat dissipation efficiency and achieving low thermal resistance heat conduction between the first electronic component and the first thermally conductive module.

Based on the first aspect, in an optional implementation, the first base plate and the first electronic component are located inside a housing of the power module. The power module further includes a heat dissipation layer. The heat dissipation layer is located between the thermally conductive module and the housing. One surface of the heat dissipation layer is in contact with the thermally conductive module, and the other surface of the heat dissipation layer is in contact with the housing. Through this implementation, the heat dissipation layer can absorb the heat from the first electronic component in a timely manner, and dissipate the heat through the housing, thereby ensuring timely heat dissipation of the first electronic component.

Based on the first aspect, in an optional implementation, the first base plate includes a first region. The first region is located between the first heat dissipation pad and a slot bottom of the first heat dissipation blind slot. A plurality of vias penetrating the first region are provided. Two ends of the via have a first hole opening and a second hole opening. The first hole opening extends to the first heat dissipation pad, and the second hole opening extends to the slot bottom of the first heat dissipation blind slot. Through this implementation, the plurality of vias can establish the heat dissipation path between the first electronic component and the first heat dissipation blind slot, thereby achieving heat dissipation of the first electronic component based on the heat dissipation path.

Based on the first aspect, in an optional implementation, the power module further includes a second heat dissipation pad and a second electronic component. The second electronic component is connected to the first surface through the second heat dissipation pad. The second heat dissipation pad has a third orthographic projection on the first surface. The first orthographic projection and the third orthographic projection are isolated from each other. The second orthographic projection at least partially overlaps the third orthographic projection. Through this implementation, one first heat dissipation blind slot can simultaneously dissipate heat for a plurality of electronic components, thereby reducing manufacturing difficulty of the power module and improving manufacturing efficiency.

Based on the first aspect, in an optional implementation, the power module further includes a second heat dissipation pad and a second electronic component. The second electronic component is connected to the first surface through the second heat dissipation pad. The second surface is further recessed to form a second heat dissipation blind slot. An orthographic projection of the second heat dissipation pad onto the first surface at least partially overlaps an orthographic projection of the second heat dissipation blind slot onto the first surface. Through this implementation, different heat dissipation blind slots dissipate heat for different electronic components, thereby ensuring reliability of heat dissipation, so that heat of electronic components can be dissipated in a timely manner.

Based on the first aspect, in an optional implementation, the power module further includes a second base plate, a third heat dissipation pad, and a third electronic component. The third electronic component is connected to a first surface of the second base plate through the third heat dissipation pad. A second surface of the second base plate is recessed to form a third heat dissipation blind slot. An orthographic projection of the third heat dissipation pad onto the first surface of the second base plate at least partially overlaps an orthographic projection of the third heat dissipation blind slot onto the first surface of the second base plate. The power module further includes a heat sink. The heat sink is located between the second surface of the first base plate and the second surface of the second base plate. A first boss of the heat sink is inserted into the first heat dissipation blind slot, and a second boss of the heat sink is inserted into the third heat dissipation blind slot. Through this implementation, the heat sink can increase contact areas of the first heat dissipation blind slot and the third heat dissipation blind slot with the outside. In this case, when the heat from electronic components is conducted to the first heat dissipation blind slot and the third heat dissipation blind slot, the heat sink absorbs the heat from the first heat dissipation blind slot and the third heat dissipation blind slot and dissipates the heat, thereby effectively improving heat dissipation efficiency.

Based on the first aspect, in an optional implementation, the first boss is in contact with a slot wall of the first heat dissipation blind slot, and the second boss is in contact with a slot wall of the third heat dissipation blind slot. An extension direction of the slot wall of the first heat dissipation blind slot intersects the first surface of the first base plate, and an extension direction of the slot wall of the third heat dissipation blind slot intersects the first surface of the second base plate. Through this implementation, the first boss is in contact with the slot wall of the first heat dissipation blind slot, and the second boss is in contact with the slot wall of the third heat dissipation blind slot, thereby effectively improving heat dissipation efficiency of the heat sink for the electronic components.

Based on the first aspect, in an optional implementation, the power module further includes a first thermally conductive layer and a second thermally conductive layer. The first thermally conductive layer is located between the slot bottom of the first heat dissipation blind slot and the first boss, and the second thermally conductive layer is located between a slot bottom of the third heat dissipation blind slot and the second boss. Through this implementation, the thermally conductive layer effectively improves efficiency of the heat sink in absorbing heat from the first electronic component and the second electronic component, and improves heat dissipation efficiency of the power module.

A second aspect of the embodiment of this application provides a communication device, including a baseband processor, a radio frequency transceiver, a power module, and an antenna that are sequentially connected. The power module is described according to any one of the first aspect. The communication device includes P transmitting channels and J receiving channels. P and J each are any integers greater than or equal to 1. Each of the J receiving channels includes a receiver in the radio frequency transceiver, a receiving module in the power module, and a receiving antenna in the antenna. Each of the P transmitting channels includes a transmitter in the radio frequency transceiver, a transmitting module in the power module, and a transmitting antenna in the antenna.

A third aspect of the embodiment of this application provides a motor controller, including a capacitor and the power module according to any one of the first aspect. The power module is electrically connected to the capacitor. The capacitor is configured to provide a voltage for the power module. The power module is configured to convert a direct current into an alternating current. The alternating current is used to drive a motor.

A fourth aspect of the embodiment of this application provides a powertrain, including a motor and the motor controller according to the third aspect connected to the motor. The motor controller is configured to provide an alternating current for the motor. The motor is configured to convert the alternating current from the motor controller into kinetic energy.

A fifth aspect of the embodiment of this application provides a vehicle, including a wheel and the powertrain according to the fourth aspect connected to the wheel. The powertrain is configured to provide power for the wheel and drive the wheel to move.

### BRIEF DESCRIPTION OF DRAWINGS

FIG. 1 is an example diagram of a first structure of an existing power module;
FIG. 2 is an example side view of a structure of a first embodiment of a power module according to this application;
FIG. 3 is an example bottom view of a structure of the power module shown in FIG. 2;
FIG. 4 is an example side view of a structure of a second embodiment of a power module according to this application;
FIG. 5 is an example side view of a structure of a third embodiment of a power module according to this application;
FIG. 6 is an example bottom view of a structure of the power module shown in FIG. 4;
FIG. 7 is an example side view of a structure of a fourth embodiment of a power module according to this application;
FIG. 8 is an example side view of a structure of a fifth embodiment of a power module according to this application;
FIG. 9 is an example diagram of a second structure of an existing power module;
FIG. 10 is an example diagram of a second structure of an existing power module;
FIG. 11 is an example diagram of a third structure of an existing power module;
FIG. 12 is an example diagram of formation of a thermally conductive module in a power module according to this application;
FIG. 13 is an example top view of a first structure of a power module according to this application;
FIG. 14 is an example diagram of heat dissipation of the power module shown in FIG. 13;
FIG. 15 is an example diagram of a structure of an embodiment of a motor controller according to this application;
FIG. 16 is an example diagram of a structure of an embodiment of a powertrain according to this application;
FIG. 17 is an example diagram of a structure of an embodiment of a vehicle according to this application; and
FIG. 18 is an example diagram of a structure of a communication device according to this application.

### DESCRIPTION OF EMBODIMENTS

This application provides a power module. The power module includes a first base plate and an electronic component connected to a surface of the first base plate. The power module provided in this embodiment of this application can improve heat dissipation efficiency of the electronic component. The power module may be various components having high heat dissipation requirements. The power module may be configured to manufacture a high heat flux density component, for example, a high-frequency component, a power component, an optical communication module, and a transceiver component for high-frequency communication. The power module may alternatively be a switching power supply. The switching power supply, also referred to as a switching-mode power supply, a switching converter, or a switching circuit, is a type of power supply. A function of the switching power supply is to convert a voltage at one level into a voltage or a current required by a user side. An input of the switching power supply is usually an alternating current power supply (for example, mains power) or a direct current power supply, and an output of the switching power supply is usually a direct current for supplying a device that requires a direct current power supply. The device that requires the direct current power supply may be a personal computer. The switching power supply performs voltage and current conversion between inputs and outputs, and is widely used in various fields such as industrial automation control, communication devices, medical devices, and digital products.

The power module provided in this embodiment of this application can effectively improve heat dissipation efficiency, meeting an increasing heat dissipation requirement of the power module under a condition that power consumption of AI, 5G, 6G, cloud computing, a supercomputing center, a server, and a router continues to increase. FIG. 2 is an example side view of a structure of a first embodiment of a power module according to this application. The power module shown in this embodiment includes a first base plate 201, M electronic components, and M heat dissipation pads. M is any integer not less than 1. A value of M is not limited in this embodiment. In an example shown in FIG. 2, M is equal to 2. In this case, the power module includes a first electronic component 210 and a second electronic component 220, and the power module further includes a first heat dissipation pad 211 and a second heat dissipation pad 221.

Specifically, the first base plate 201 may be a printed circuit board (printed circuit board, PCB), a substrate (Substrate), a base, or the like. The first base plate 201 may alternatively be a high thermal conductivity plate, such as ST110G and ST115, with a thermal conductivity of about 1 W/(m·K) (W/(m·K)). The first base plate 201 shown in this embodiment has a first surface 202 and a second surface 203 that are opposite to each other in a direction Z. The direction Z is perpendicular to the first surface 202 of the first base plate 201. The first surface 202 is parallel to an XY plane. The XY plane includes a direction X and a direction Y. The direction X is perpendicular to the direction Y. The direction Z is perpendicular to the XY plane. In this embodiment, an example in which the direction Z is perpendicular to the first surface 202 is used. In another example, the direction Z only needs to intersect the first surface 202, and an included angle between the direction Z and the first surface 202 is not limited. It may be understood that, when the direction Z intersects the first surface 202, the first surface 202 and the second surface 203 are two opposite surfaces of the first base plate 201. When the first base plate 201 is the PCB, the first base plate 201 includes one or more layers of board material, and conductive traces are arranged on one or two sides of each plate. A type of the board material is not limited in this embodiment. For example, the board material may be paper-based, glass fiber cloth-based, composite-based, ceramic-based, metal core-based, or the like.

The first electronic component 210 is connected to the first surface 202 of the first base plate 201 through the first heat dissipation pad 211. The second electronic component 220 is connected to the first surface 202 of the first base plate 201 through the second heat dissipation pad 221. The first heat dissipation pad 211 and the second heat dissipation pad 221 are located at different positions on the first surface 202. The first electronic component 210 is used as an example. The first electronic component 210 may be a power chip. The power chip may be made of silicon (Silicon, Si), germanium (Ge), gallium arsenide (gallium arsenide, GaAs), indium phosphide (indium phosphide, InP), a wide bandgap semiconductor, or the like. The wide bandgap semiconductor may be silicon carbide (silicon carbide, SiC), gallium nitride (gallium nitride, GaN), or the like. For example, the first electronic component 210 is a wide bandgap semiconductor. When the first electronic component 210 is the wide bandgap semiconductor, the power module can develop toward high power, high density, and high integration. It should be noted that a type of the first electronic component 210 is not limited in this embodiment. For example, the first electronic component 210 may be any type of electronic component, for example, a radio frequency (radio frequency, RF) power amplifier, a digital signal amplifier, an analog signal amplifier, a hybrid electric vehicle insulated gate bipolar transistor (insulate-gate bipolar transistor, IGBT) module, a metal-oxide-semiconductor field-effect transistor (metal-oxide-semiconductor field-effect transistor, MOSFET), a high-performance light-emitting diode (light-emitting diode, LED), a resistor, a capacitor, or an inductor. For descriptions of the second electronic component 220, refer to the descriptions of the first electronic component 210. Details are not described again. The first heat dissipation pad 211 is used as an example. The first heat dissipation pad 211 can solder the first electronic component 210 onto the first surface 202 of the first base plate 201. In addition, the first heat dissipation pad 211 can further dissipate heat for the first electronic component 210, to improve heat dissipation efficiency of the first electronic component 210, reduce an operating temperature of the first electronic component 210, and improve reliability and stability of the first electronic component 210. For descriptions of the second heat dissipation pad 221, refer to the descriptions of the first heat dissipation pad 211. Details are not described again.

The first electronic component 210 is still used as an example. To improve the heat dissipation efficiency of the first electronic component 210, the second surface 203 of the first base plate 201 shown in this embodiment is recessed to form a first heat dissipation blind slot (blind slot) 231. In this case, an accommodation cavity of the first heat dissipation blind slot 231 is located inside the first base plate 201. A slot opening of the first heat dissipation blind slot 231 is located on the second surface 203 of the first base plate 201, and extends into the first base plate 201 to form the accommodation cavity of the first heat dissipation blind slot 231. In addition, in the direction Z, a cavity length of the accommodation cavity is less than a height of the first base plate 201. In other words, in the direction Z, the first heat dissipation blind slot 231 does not penetrate the first base plate 201. In this embodiment, the first heat dissipation pad 211 has a first orthographic projection on the first surface 202, and the first heat dissipation blind slot 231 has a second orthographic projection on the first surface 202. To make first heat dissipation blind slot 231 dissipate heat from the first electronic component 210, the first orthographic projection at least partially overlaps the second orthographic projection. Specifically, the first orthographic projection is an orthographic projection formed by projecting the first heat dissipation pad 211 onto the first surface 202 along a plurality of projection lines parallel to each other. Each projection line is perpendicular to the first surface 202. Similarly, the second orthographic projection is an orthographic projection formed by projecting the first heat dissipation blind slot 231 onto the first surface 202 along a plurality of projection lines parallel to each other. The first heat dissipation pad 211 absorbs the heat from the first electronic component 210. When the first orthographic projection at least partially overlaps the second orthographic projection, the heat absorbed by the first heat dissipation pad 211 can be successfully dissipated by the first heat dissipation blind slot 231, thereby ensuring successful heat dissipation of the first electronic component 210.

The first heat dissipation blind slot 231 shown in this embodiment is a metalized heat dissipation blind slot. Specifically, after the first heat dissipation blind slot 231 is formed, a metal layer 232 is plated on a cavity wall of the accommodation cavity of the first heat dissipation blind slot 231. The metal layer 232 may be implemented in an electroplating (Electroplate) manner. This is not specifically limited. For example, the metal layer 232 may further be implemented by a process such as electroless plating or vacuum deposition. The metal layer 232 can effectively improve the heat dissipation efficiency of the first electronic component 210.

The first base plate 201 shown in this embodiment includes a first region. In the direction Z, the first region is located between the first heat dissipation pad 211 and a slot bottom of the first heat dissipation blind slot 231. The first region is provided with a plurality of vias (through vias) 233 in the direction Z. Each via 233 connects the first heat dissipation pad 221 and the slot bottom of the first heat dissipation blind slot 231, and the via 233 penetrates the first region in the direction Z. Specifically, two ends of the via 233 have a first hole opening and a second hole opening in the direction Z. The first hole opening extends to the first heat dissipation pad 221. The second hole opening extends to the slot bottom of the first heat dissipation blind slot 231. In this case, the via 233 establishes a heat dissipation path between the first heat dissipation pad 221 and the first heat dissipation blind slot 231 in the direction Z. A part of heat generated by the first electronic component 210 is dissipated through the heat dissipation pad 221, and the other part of the heat is conducted to the first heat dissipation blind slot 231 through the plurality of vias 233. The heat is dissipated by the first heat dissipation blind slot 231, thereby achieving heat dissipation of the first electronic component 210. The first heat dissipation blind slot 231 shown in this embodiment is formed by recessing the second surface 203 of the first base plate 201, thereby effectively shortening a length of a heat dissipation path between the first heat dissipation blind slot 231 and the first electronic component 210 in the direction Z, reducing thermal resistance (thermal resistance), and improving the heat dissipation efficiency of the first electronic component 210. In addition, the metal layer 232 of the first heat dissipation blind slot 231 has good thermal conductivity. Therefore, when the heat generated by the first electronic component 210 is transferred to the first heat dissipation blind slot 231, the heat can be dissipated through the metal layer 232, thereby improving heat dissipation efficiency. A depth of the via 233 in the direction Z is not limited in this embodiment, provided that the via 233 can establish the heat dissipation path between the first heat dissipation pad 221 and the first heat dissipation blind slot 231. For example, in the direction Z, the depth of the via 233 is less than a thickness of the first base plate 201. To ensure mechanical strength of the first base plate 201 and further ensure the heat dissipation efficiency of the first electronic component 210, the depth of the via 233 is greater than or equal to 1/2 of a plate thickness in the direction Z, and the plate thickness is a thickness of the first base plate 201 in the direction Z.

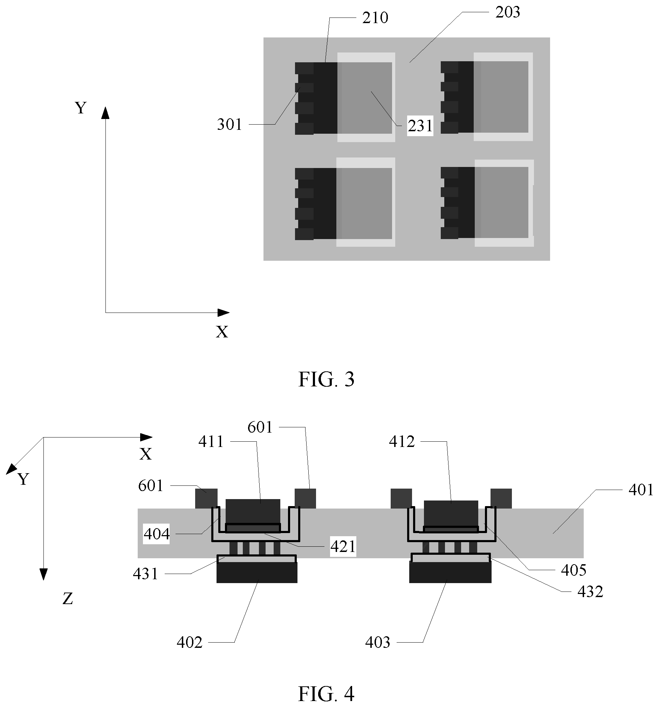

FIG. 3 is an example bottom view of a structure of the power module shown in FIG. 2. A signal pin 301 of the first electronic component 210 is led out from the second surface 203 of the first base plate 201. The signal pin 301 is configured to achieve circuit connection and signal transmission of the first electronic component 210. A position of the first heat dissipation blind slot 231 on the second surface 203 shown in this embodiment is different from a position of the signal pin 301 on the second surface. In other words, the position of the first heat dissipation blind slot 231 on the second surface 203 avoids the position of the signal pin 301 on the second surface. In this case, an orthographic projection of the first heat dissipation blind slot 231 onto the first surface 202 is separated from an orthographic projection of the signal pin 301 onto the first surface 202. It should be noted that, in another example, the position of the first heat dissipation blind slot 231 on the second surface 203 may alternatively not avoid the signal pin 301. This is not specifically limited. For descriptions of a structure of the second heat dissipation blind slot 241 used for dissipating heat from the second electronic device 220, refer to the descriptions of a structure of the first heat dissipation blind slot 231 used for dissipating heat from the first electronic device 210. Details are not described again.

A manner in which heat dissipated from the first heat dissipation blind slot 231 is dissipated from the power module is not limited in this embodiment. For example, the power module may reliably dissipate the heat dissipated from the first heat dissipation blind slot 231 from the power module in a manner such as self-cooling (self-cooling), air cooling (air cooling), or liquid cooling (liquid cooling). Self-cooling means that the heat from the first electronic component 210 in the first heat dissipation blind slot 231 is dissipated by natural circulation of a surrounding cooling medium. Air cooling means that the power module includes a fan (also referred to as a blower), and the fan can increase a rate at which air flows through the first heat dissipation blind slot 231 per unit time, to achieve heat exchange between air inside the power module and external air, and to dissipate heat in the first heat dissipation blind slot 231. Liquid cooling means that the first heat dissipation blind slot 231 is connected to a liquid cooling pipe, a liquid coolant flows in the liquid cooling pipe, and the liquid coolant can carry away heat in the first heat dissipation blind slot 231. It should be noted that a manner in which the heat in the first heat dissipation blind slot 231 is dissipated is not limited in this embodiment.

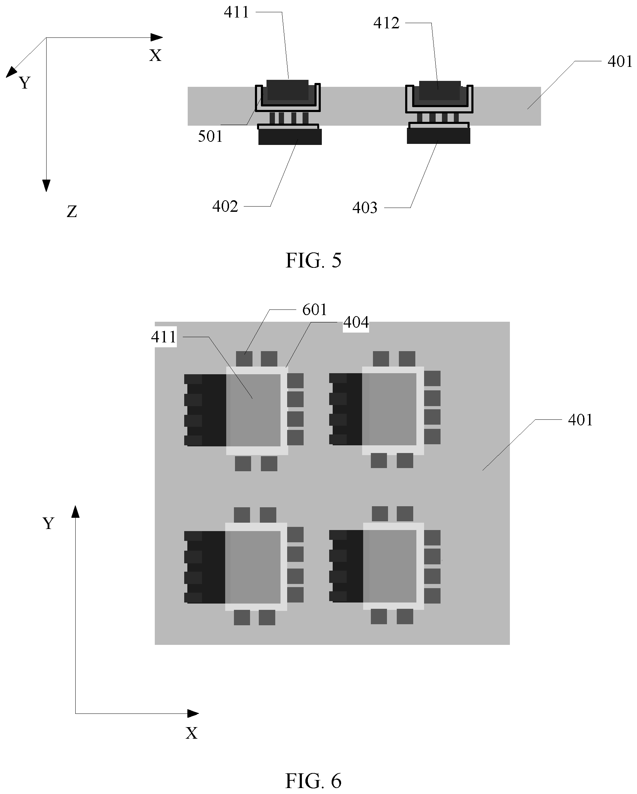

FIG. 4 is an example side view of a structure of a second embodiment of a power module according to this application. The power module shown in this embodiment includes a first base plate 401, a first electronic component 402, a second electronic component 403, a first heat dissipation pad 431, a second heat dissipation pad 432, a first heat dissipation blind slot 404, and a second heat dissipation blind slot 405. For specific descriptions, refer to the descriptions corresponding to FIG. 2 and FIG. 3. Details are not described again. The power module shown in this embodiment further includes a first thermally conductive module 411 and a second thermally conductive module 412. The first thermally conductive module 411 is located in an accommodation cavity of the first heat dissipation blind slot 404, and the second thermally conductive module 412 is located in an accommodation cavity of the second heat dissipation blind slot 405. The first thermally conductive module 411 is used as an example. To achieve a reliable connection between the first thermally conductive module 411 and the first heat dissipation blind slot 404, and to prevent the first thermally conductive module 411 from detaching from the first heat dissipation blind slot 404 during subsequent use of the power module, a solder sheet 421 is prefabricated on a surface of a slot bottom of the first heat dissipation blind slot 404. FIG. 5 is an example side view of a structure of a third embodiment of a power module according to this application. In this embodiment, a solder sheet 501 may also be prefabricated on a cavity wall surface of an accommodation cavity of a first heat dissipation blind slot 404. In this case, the solder sheet 501 is disposed in all gaps between the first heat dissipation blind slot 404 and a first thermally conductive module 411. A position and an area of the prefabricated solder sheet are not limited in this embodiment, provided that the prefabricated solder sheet is connected to the first heat dissipation blind slot 404 and the first thermally conductive module 411. Then, the first thermally conductive module 411 is soldered into the first heat dissipation blind slot 404 through reflow soldering, and after the prefabricated solder sheet is heated and melted, liquid solder paste is formed to fill the gap between the first thermally conductive module 411 and the first heat dissipation blind slot 404. In this embodiment, an example in which the first thermally conductive module 411 is connected to the first heat dissipation blind slot 404 through soldering is used. This is not limited. For example, the first thermally conductive module 411 may alternatively be reliably connected to the first heat dissipation blind slot 404 through bonding, screw locking, snap-fitting, press-fitting, or any other manner. A material of the first thermally conductive module 411 is not limited in this embodiment, provided that the first thermally conductive module 411 is made of a high thermally conductive material. For example, the first thermally conductive module 411 may be made of a high thermally conductive substance such as a metal, ceramic, and a composite material. If the first thermally conductive module 411 is made of a ceramic material, thermal gel is applied onto a surface of a slot bottom of the first heat dissipation blind slot 404, and the thermal gel is located between the slot bottom of the first heat dissipation blind slot 404 and the first thermally conductive module 411 made of ceramic. Through reflow soldering, the thermal gel is heated and cured, and the cured thermal gel bonds the first thermally conductive module 411 made of ceramic to the inside of the accommodation cavity of the first heat dissipation blind slot 404.

With reference to FIG. 4 and FIG. 6, FIG. 6 is an example bottom view of a structure of the power module shown in FIG. 4. On a second surface of the first base plate 401, a solder block 601 is prefabricated at a position close to a slot opening of the first heat dissipation blind slot 404. A quantity of solder blocks 601 is not limited in this embodiment, provided that a plurality of solder blocks 601 are on the second surface of the first base plate 401 and close to the slot opening of the first heat dissipation blind slot 404. For example, the plurality of solder blocks 601 shown in this example surround the slot opening of the first heat dissipation blind slot 404. The structure shown in this example is used. During reflow soldering of the power module, after the solder block 601 is heated and melted, liquid solder paste is formed and extends into the first heat dissipation blind slot 404. In addition, the liquid solder paste can flow along a slot wall of the first heat dissipation blind slot 404 to a gap between the first heat dissipation blind slot 404 and the first thermally conductive module 411, thereby achieving soldering between the first heat dissipation blind slot 404 and the first thermally conductive module 411.

In examples shown in FIG. 4 to FIG. 6, because there is the solder paste between the first heat dissipation blind slot 404 and the first thermally conductive module 411, and the solder paste has thermal conductivity, a part of heat generated by the first electronic component 402 is dissipated through the solder paste, and the other part of the heat is conducted to the first thermally conductive module 411, so that the first thermally conductive module 411 dissipates the heat, thereby improving heat dissipation efficiency and achieving low thermal resistance heat conduction between the first electronic component 402 and the first thermally conductive module 411. For descriptions of the second heat dissipation blind slot 405 and a connection between the second heat dissipation blind slot 405 and the second electronic component 403 shown in this embodiment, refer to the descriptions of the first heat dissipation blind slot 404 and a connection between the first heat dissipation blind slot 404 and the first electronic component 402. Details are not described again.

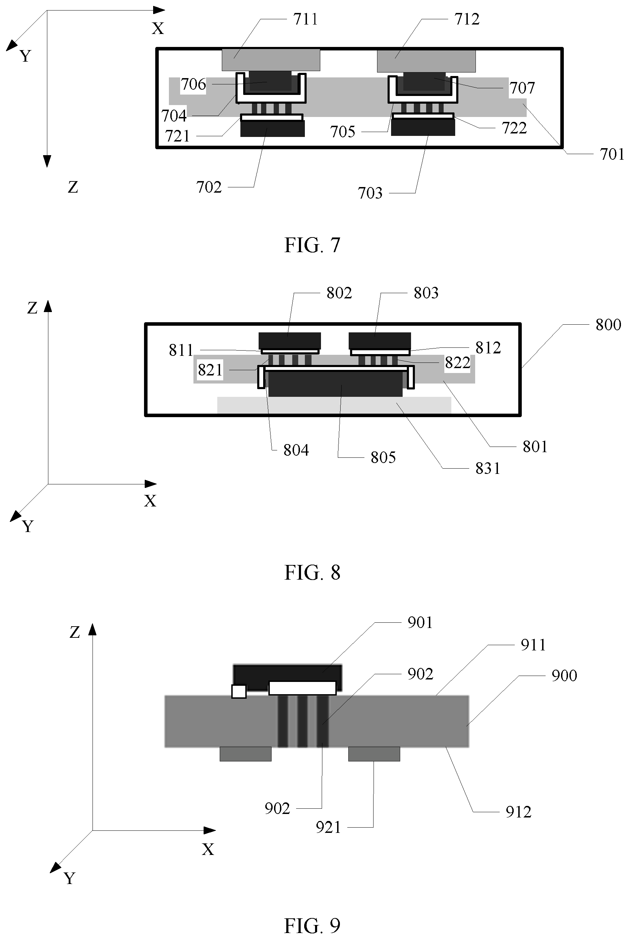

FIG. 7 is an example side view of a structure of a fourth embodiment of a power module according to this application. The power module shown in this embodiment includes a housing 700. A first base plate 701, a first electronic component 702, a second electronic component 703, a first heat dissipation blind slot 704, a second heat dissipation blind slot 705, a first heat dissipation pad 721, a second heat dissipation pad 722, a first thermally conductive module 706, and a second thermally conductive module 707 are packaged in the housing 700. For specific descriptions of the first base plate 701, the first electronic component 702, the second electronic component 703, the first heat dissipation blind slot 704, the second heat dissipation blind slot 705, the first heat dissipation pad 721, the second heat dissipation pad 722, the first thermally conductive module 706, and the second thermally conductive module 707, refer to FIG. 4 to FIG. 6. Details are not described again. The power module shown in this embodiment further includes a first heat dissipation layer 711 and a second heat dissipation layer 712. In a direction Z, the first heat dissipation layer 711 is located between the first thermally conductive module 706 and the housing 700, and the second heat dissipation layer 712 is located between the second thermally conductive module 707 and the housing 700. For example, in this embodiment, one side of the first heat dissipation layer 711 is in contact with the first thermally conductive module 706, and the other side of the first heat dissipation layer 711 is in contact with the housing 700. The first heat dissipation layer 711 is used as an example. The first heat dissipation layer 711 is made of a thermally conductive material, so that heat from the first electronic component 702 is dissipated from the housing 700 through the first heat dissipation blind slot 704, the first thermally conductive module 706, and the first heat dissipation layer 711, thereby effectively improving heat dissipation efficiency. A specific material of the first heat dissipation layer 711 is not limited in this embodiment. For example, the first heat dissipation layer 711 may be made of a thermal pad, thermal gel, thermal grease, or the like. The thermal pad (also referred to as a thermal silicon pad, a thermally conductive silicon pad, a thermal silicone pad, or the like) is a high-performance gap-filled thermally conductive material, and has good adhesiveness, flexibility, good compression performance, and excellent thermal conductivity. The thermal gel (also referred to as heat sink gel, processor gel, thermal adhesive, thermal silicone rubber, or the like) is a gel-like silicone-based thermally conductive material. The thermal grease (also referred to as heat dissipation paste or thermally conductive paste) is a highly thermally conductive and insulating silicone material.

In the foregoing example, a quantity of heat dissipation blind slots included in the power module is equal to a quantity of electronic components. In other words, one heat dissipation blind slot is used to dissipate heat for only one electronic component. An example in which one heat dissipation blind slot shown in this embodiment can dissipate heat for at least two electronic components is used. FIG. 8 is an example side view of a structure of a fifth embodiment of a power module according to this application. The power module shown in this embodiment includes a housing 800. A first base plate 801, a first electronic component 802, a second electronic component 803, a first heat dissipation blind slot 804, a first heat dissipation pad 811, a second heat dissipation pad 812, and a first thermally conductive module 805 are packaged in the housing 800. For descriptions of the housing 800, the first electronic component 802, and the second electronic component 803 shown in this embodiment, refer to any embodiment shown in FIG. 2 to FIG. 7. Details are not described again. A difference between this embodiment and FIG. 4 to FIG. 6 lies in that the first heat dissipation blind slot 804 shown in this embodiment is configured to simultaneously dissipate heat for a plurality of electronic components (for example, the first electronic component 802 and the second electronic component 803). Specifically, the first heat dissipation pad 811 configured to solder the first electronic component 802 has a first orthographic projection on a first surface of the first base plate 801. The first heat dissipation blind slot 804 has a second orthographic projection on the first surface of the first base plate 801. The second heat dissipation pad 812 configured to solder the second electronic component 803 has a third orthographic projection on the first surface of the first base plate 801. The first orthographic projection and the third orthographic projection are isolated from each other. The first orthographic projection at least partially overlaps the second orthographic projection. The third orthographic projection at least partially overlaps the second orthographic projection. For descriptions of the first orthographic projection, the second orthographic projection, and the third orthographic projection, refer to the descriptions corresponding to FIG. 2. Details are not described again. Specifically, the first base plate 801 includes a first region and a second region. In a direction Z, the first region is located between the first heat dissipation pad 811 and the first heat dissipation blind slot 804. The second region is located between the second heat dissipation pad 812 and the first heat dissipation blind slot 804. For descriptions of the first heat dissipation pad 811 and the second heat dissipation pad 812, refer to descriptions corresponding to FIG. 2. Details are not described again. A plurality of first vias 821 are provided in the first region in the direction Z. A plurality of second vias 822 are provided in the second region in the direction Z. For descriptions of the first via 821 and the second via 822, refer to descriptions corresponding to FIG. 2. Details are not described again. The first via 821 connects the first surface of the first base plate 801 and a slot bottom of the first heat dissipation blind slot 804. In addition, the first via 821 penetrates the first region in the direction Z. The first via 821 establishes a heat dissipation path between the first heat dissipation pad 811 and the first heat dissipation blind slot 804. Similarly, the second via 822 connects the first surface of the first base plate 801 and the slot bottom of the first heat dissipation blind slot 804. In addition, the second via 822 penetrates the second region in the direction Z. The second via 822 establishes a heat dissipation path between the second heat dissipation pad 812 and the first heat dissipation blind slot 804. In this case, one part of heat generated by the first electronic component 802 and the second electronic component 803 is dissipated through the first heat dissipation pad 811 and the second heat dissipation pad 812, the other part of the heat is conducted to the first heat dissipation blind slot 804 through the plurality of first vias 821 and the plurality of the second vias 822, and the heat is dissipated by the first heat dissipation blind slot 804, thereby achieving simultaneous heat dissipation for the first electronic component 802 and the second electronic component 803 through a same first heat dissipation blind slot 804. For descriptions of the first heat dissipation blind slot 804 simultaneously dissipating heat for the first electronic component 802 and the second electronic component 803, refer to the descriptions corresponding to FIG. 2 in which the first heat dissipation blind slot dissipates heat for the first electronic component. Details are not described again. In this embodiment, to improve heat dissipation efficiency, the first heat dissipation blind slot 804 further includes the first thermally conductive module 805. For descriptions of the first thermally conductive module 805 and descriptions of improving heat dissipation efficiency by the first thermally conductive module 805, refer to the descriptions corresponding to FIG. 4 to FIG. 6. Details are not described again. The power module shown in this embodiment further includes a first heat dissipation layer 831. In the direction Z, the first heat dissipation layer 831 is located between the first thermally conductive module 805 and the housing 800. For descriptions of the first heat dissipation layer 831 and descriptions of improving heat dissipation efficiency by the first heat dissipation layer 831, refer to the descriptions of the first heat dissipation layer corresponding to FIG. 7. Details are not described again.

To better understand beneficial effects of the power module provided in embodiments of this application, the following describes with reference to existing solutions.

FIG. 9 is an example diagram of a second structure of an existing power module. A first surface 911 of an existing first base plate 900 includes an electronic component 901. A plurality of vias 902 penetrating the entire first base plate 900 in a direction Z are provided. The via 902 extends to a second surface 912 of the first base plate 900. In an example shown in FIG. 9, the via 902 dissipates heat from the electronic component 901. However, the existing via 902 penetrates the entire first base plate 900 in the direction Z. Therefore, in the direction Z, a length of the via 902 is almost equal to a height of the first base plate 900, resulting in a long heat dissipation path between the electronic component 901 and the second surface 912 in the direction Z, and poor heat dissipation effect. However, as shown in this embodiment, because a heat dissipation blind slot is recessed into a first base plate, a length of a via between an electronic component and the heat dissipation blind slot in a direction Z is shortened, thereby shortening a length of a heat dissipation path in the direction Z for dissipating heat for the electronic component, and improving heat dissipation efficiency. Because the power module shown in this embodiment effectively shortens the length of the heat dissipation path in the direction Z for dissipating heat for the electronic component, a temperature of the electronic component during operation is effectively reduced, thereby ensuring that heat generated by the electronic component during operation is dissipated in a timely manner. In the example shown in FIG. 9, to improve heat dissipation efficiency, solder paste 921 may be formed at the hole opening of the via 902 on the second surface 912 through solder paste stencil printing at a position near a hole opening of the via 902 on the second surface 912. The solder paste 921 flows to the first surface 911 along a hole wall of the via 902. Thermal conductivity of the solder paste can improve efficiency of conducting heat from the electronic component 901 out through the via 902. However, during solder paste stencil printing, the solder paste flows onto a bright copper region on the first surface 911, affecting solder printing on the first base plate 900, consequently affecting a layout of another electronic component on the first surface 911, and a high-density layout of the electronic component on the first surface 911 cannot be achieved. However, as shown in this embodiment of this application, for example, as shown in FIG. 4 and FIG. 6, even if a solder block 601 becomes liquid solder paste at a high temperature, and the solder paste flows into a first heat dissipation blind slot 404. In addition, the first heat dissipation blind slot 404 and a first surface are in an isolated state (that is, not in communication with each other). Therefore, due to blocking by the first heat dissipation blind slot 404, the solder paste cannot flow to the first surface, so that a layout of another electronic component on the first surface is not affected, thereby further helping achieve a high-density layout of the electronic component.

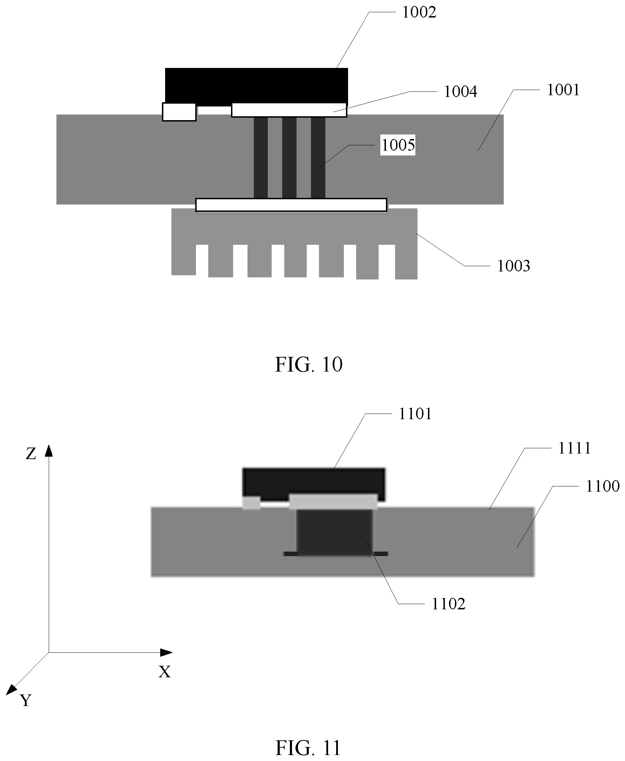

FIG. 10 is an example diagram of a second structure of an existing power module. The power module includes a first base plate 1001. A first surface of the first base plate 1001 is connected to an electronic component 1002, and a second surface of the first base plate 1001 is connected to a heat sink 1003. The electronic component 1002 is soldered to the first surface of the first base plate 1001 through a heat dissipation pad 1004. The first base plate 1001 includes a plurality of vias 1005 located between the heat dissipation pad 1004 and the heat sink 1003. Heat generated by the electronic component 1002 is sequentially conducted through the heat dissipation pad 1004, the via 1005, and the heat sink 1003, and is dissipated through the heat sink 1003. However, due to a large contact area between the heat sink 1003 and the second surface of the first base plate 1001, a high-density layout of electronic components on the first base plate 1001 cannot be achieved. The heat sink 1003 and the second surface of the first base plate 1001 are soldered together by solder during reflow soldering. During reflow soldering, flux helps the solder to wet and connect the heat sink 1003. However, due to blocking of the heat sink 1003, there is no escape path for volatilization of the flux. Consequently, gas formed by the flux volatilization cannot be smoothly discharged. In this case, the gas generated by the flux volatilization increases a void ratio of the solder, reducing heat dissipation efficiency. However, in a power module shown in this embodiment, a first heat dissipation blind slot configured to dissipate heat for a first electronic component is recessed into a second surface of a first base plate, and a first thermally conductive module is directly disposed in an accommodation cavity of the first heat dissipation blind slot. Therefore, the first heat dissipation blind slot does not occupy an area of the second surface of the first base plate, and the first heat dissipation blind slot does not affect a high-density layout of electronic components on the first base plate. In addition, disposition of the first heat dissipation blind slot shown in this embodiment effectively suppresses an increase in an overall height of the power module in a direction Z that would otherwise be required for heat dissipation, thereby improving integration of the power module. The first heat dissipation blind slot does not block an escape path of flux, thereby improving heat dissipation efficiency, reducing a void ratio of the first base plate, and improving reliability.

FIG. 11 is an example diagram of a third structure of an existing power module. The existing power module shown in FIG. 11 includes a first base plate 1100. A first surface 1111 of the existing first base plate 1100 includes an electronic component 1101. To achieve heat dissipation for the electronic component 1101, a thermally conductive module 1102 (for example, a copper block) is placed on the first surface 1111, and the thermally conductive module 1102 is press-fitted together with the first base plate 1100, so that the thermally conductive module 1102 is pressed into the first base plate 1100 through the first surface 1111. In this case, the electronic component 1101 dissipates heat through the thermally conductive module 1102. However, pressing the thermally conductive module 1102 into the first base plate 1100 increases a processing process of the first base plate, resulting in high processing costs of the first base plate and low manufacturing efficiency. In addition, an interface on which the thermally conductive module 1102 is in contact with a dielectric layer of the first base plate 1100 is prone to delamination under pressure, consequently reducing quality reliability of the first base plate. However, in a power module shown in this embodiment of this application, a first thermally conductive module is directly connected to a preset accommodation cavity of a first heat dissipation blind slot, thereby reducing processing process complexity of a first base plate, reducing processing costs, and improving processing efficiency.

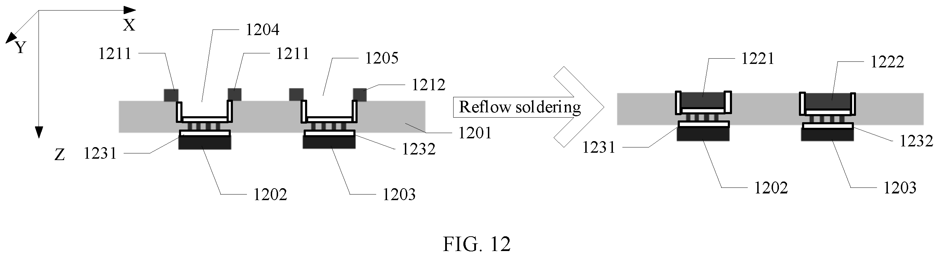

FIG. 12 is an example diagram of formation of a thermally conductive module in a power module according to this application. The thermally conductive module shown in FIG. 12 is different from thermally conductive modules in embodiments shown in FIG. 4 to FIG. 6. In embodiments shown in FIG. 4 to FIG. 6, a solder block is configured to achieve a connection between a first thermally conductive module and a first heat dissipation blind slot. In the embodiment shown in FIG. 12, the thermally conductive module is directly formed by the solder block. Specifically, the power module shown in this embodiment includes a first base plate 1201, a first electronic component 1202, a second electronic component 1203, a first heat dissipation pad 1231, a second heat dissipation pad 1232, a first heat dissipation blind slot 1204, and a second heat dissipation blind slot 1205. For specific descriptions of the first base plate 1201, the first electronic component 1202, the second electronic component 1203, the first heat dissipation pad 1231, the second heat dissipation pad 1232, the first heat dissipation blind slot 1204, and the second heat dissipation blind slot 1205, refer to the descriptions corresponding to FIG. 2. Details are not described again. The first blind slot 1204 is used as an example. On a second surface of the first base plate 1201, a prefabricated solder block 1211 is surface-mounted at a position close to a slot opening of the first blind slot 1204. For example, as shown in FIG. 12, on the second surface of the first base plate 1201, the prefabricated solder block may be surface-mounted around the slot opening of the first blind slot 1204. A quantity of the solder blocks 1211 is not limited in this embodiment, provided that the solder block 1211 is close to the slot opening of the first blind slot 1204, to ensure that, during reflow soldering, the solder block 1211 turns into liquid solder paste, and the solder paste flows along a slot wall of the first blind slot 1204 to fill an accommodation cavity of the first blind slot 1204, thereby forming a first thermally conductive module 1221 in the accommodation cavity. Similarly, on the second surface of the first base plate 1201, a prefabricated solder block 1212 is surface-mounted at a position close to a slot opening of the second blind slot 1205, to ensure that, during reflow soldering, the solder block 1212 turns into liquid solder paste, and the solder paste flows along a slot wall of the second blind slot 1205 to fill an accommodation cavity of the second blind slot 1205, thereby forming a second thermally conductive module 1222 in the accommodation cavity. For descriptions of dissipation of heat from the electronic component by the first thermally conductive module 1221 and the second thermally conductive module 1222 formed by the solder paste, refer to FIG. 4 to FIG. 6. Details are not described again. In this embodiment, a first heat dissipation layer may be included between the first thermally conductive module 1221 and a housing, and a second heat dissipation layer may be included between the second thermally conductive module 1222 and the housing. For descriptions of the first heat dissipation layer and the second heat dissipation layer, refer to the descriptions corresponding to FIG. 7. Details are not described again. In the embodiment shown in FIG. 12, an example in which one heat dissipation blind slot is configured to dissipate heat for only one electronic component is used. One heat dissipation blind slot shown in this embodiment can dissipate heat for at least two electronic components. For specific descriptions, refer to the descriptions corresponding to FIG. 8. Details are not described again.

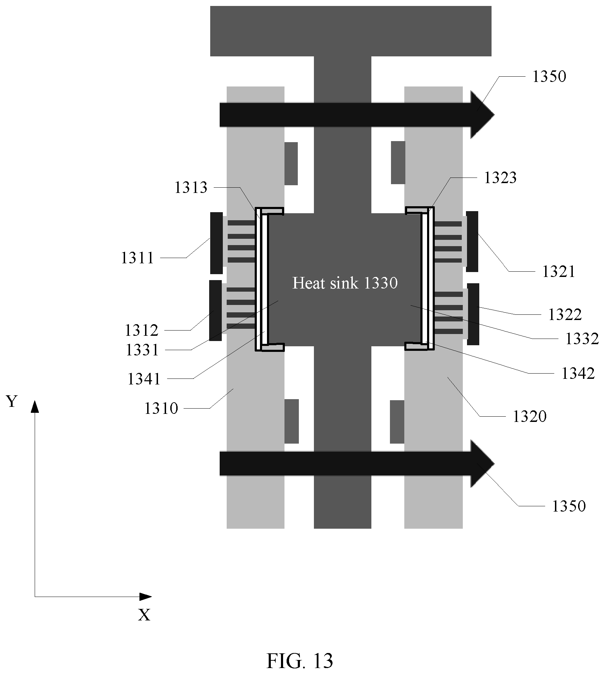

FIG. 13 is an example top view of a first structure of a power module according to this application. The power module shown in this embodiment includes a first base plate 1310 and a second base plate 1320. A first surface of the first base plate 1310 includes a first electronic component 1311 and a second electronic component 1312, and a first surface of the second base plate 1320 includes a third electronic component 1321 and a fourth electronic component 1322. A first heat dissipation blind slot 1313 is recessed into a second surface of the first base plate 1310, and a third heat dissipation blind slot 1323 is recessed into a second surface of the second base plate 1320. For descriptions of the first base plate 1310, the second base plate 1320, the first electronic component 1311, the second electronic component 1312, the third electronic component 1321, the fourth electronic component 1322, the first heat dissipation blind slot 1313, and the third heat dissipation blind slot 1323, refer to the foregoing embodiment. Details are not described again. In this embodiment, an example in which one first heat dissipation blind slot 1313 dissipates heat for a plurality of electronic components (that is, the first electronic component 1311 and the second electronic component 1312 shown in this embodiment), and one third heat dissipation blind slot 1323 dissipates heat for a plurality of electronic components (that is, the third electronic component 1321 and the fourth electronic component 1322 shown in this embodiment) is used. For specific descriptions, refer to the descriptions corresponding to FIG. 8. Details are not described again. It should be noted that a quantity of electronic components for which one first heat dissipation blind slot can dissipate heat is not limited in this embodiment. The power module shown in this embodiment further includes a heat sink 1330. The heat sink 1330 is located between the second surface of the first base plate 1310 and the second surface of the second base plate 1320. The heat sink 1330 extends toward the first base plate 1310 to form a first boss 1331. The heat sink 1330 extends toward the second base plate 1320 to form a second boss 1332. The first boss 1331 is inserted into the first heat dissipation blind slot 1313, and the second boss 1332 is inserted into the third heat dissipation blind slot 1323. In this embodiment, the heat sink 1330 is made of metal. For example, the heat sink 1330 is made of metal such as aluminum and copper. The heat sink 1330 is configured to increase contact areas of the first heat dissipation blind slot 1313 and the third heat dissipation blind slot 1323 with the outside. In this case, when heat from electronic components is conducted to the first heat dissipation blind slot 1313 and the third heat dissipation blind slot 1323, the heat sink 1330 absorbs the heat from the first heat dissipation blind slot 1313 and the third heat dissipation blind slot 1323 and dissipates the heat. To ensure heat dissipation efficiency of the heat sink 1330 for the electronic components, the first boss 1331 is in contact with a slot wall of the first heat dissipation blind slot 1313, and the second boss 1332 is in contact with a slot wall of the third heat dissipation blind slot 1323. An extension direction of the slot wall of the first heat dissipation blind slot 1313 intersects the first surface of the first base plate 1310, and an extension direction of the slot wall of the third heat dissipation blind slot 1323 intersects the first surface of the second base plate 1320. For example, as shown in FIG. 13, the slot wall of the first heat dissipation blind slot 1313 extends in a direction X. It should be noted that, in this embodiment, an example in which the slot wall of the first heat dissipation blind slot 1313 extends in the direction X is used. In another example, there may be an included angle between the extension direction of the slot wall of the first heat dissipation blind slot 1313 and the direction X. This is not specifically limited. For descriptions of the slot wall of the third heat dissipation blind slot 1323, refer to the descriptions of the slot wall of the first heat dissipation blind slot 1313. Details are not described again. To further improve the heat dissipation efficiency of the heat sink 1330 for the electronic components, the power module further includes a first thermally conductive layer 1341 and a second thermally conductive layer 1342. The first thermally conductive layer 1341 is located between a slot bottom of the first heat dissipation blind slot 1313 and the first boss 1331, and the second thermally conductive layer 1342 is located between a slot bottom of the third heat dissipation blind slot 1323 and the second boss 1332. In this case, the first thermally conductive layer 1341 can conduct heat from the first electronic component 1311 and the second electronic component 1312 to the first boss 1331, to improve efficiency of the heat sink 1330 in absorbing the heat from the first electronic component 1311 and the second electronic component 1312. Similarly, the second thermally conductive layer 1342 can conduct heat from the third electronic component 1321 and the fourth electronic component 1322 to the second boss 1332, to improve efficiency of the heat sink 1330 in absorbing the third electronic component 1321 and the fourth electronic component 1322.

A manner in which the heat sink 1330 is connected to the first base plate 1310 and the second base plate 1320 is not limited in this embodiment. For example, a screw 1350 may pass through the first base plate 1310, the heat sink 1330, and the second base plate 1320, to achieve a fastened connection between the first base plate 1310, the heat sink 1330, and the second base plate 1320 through the screw 1350, thereby ensuring that the power module forms an integrated heat dissipation component, and improving structural reliability of the power module. It should be noted that descriptions of a connection manner between the first base plate 1310, the heat sink 1330, and the second base plate 1320 is not limited in this embodiment. For example, the connection may be achieved through soldering, bonding, snap-fitting, or any other manner. As shown in this embodiment, a distance between the first base plate 1310 and the second base plate 1320 can be achieved by a width of the heat sink 1330 in the direction X. In this way, another electronic component can be arranged on the second surface of the first base plate 1310 and the second base plate 1320, thereby increasing layout density of the electronic components on the power module and achieving a high-density layout of the electronic components. Optionally, the heat sink 1330 shown in this embodiment may include heat dissipation fins, and efficiency of heat dissipation for the electronic component is improved by the heat dissipation fins.

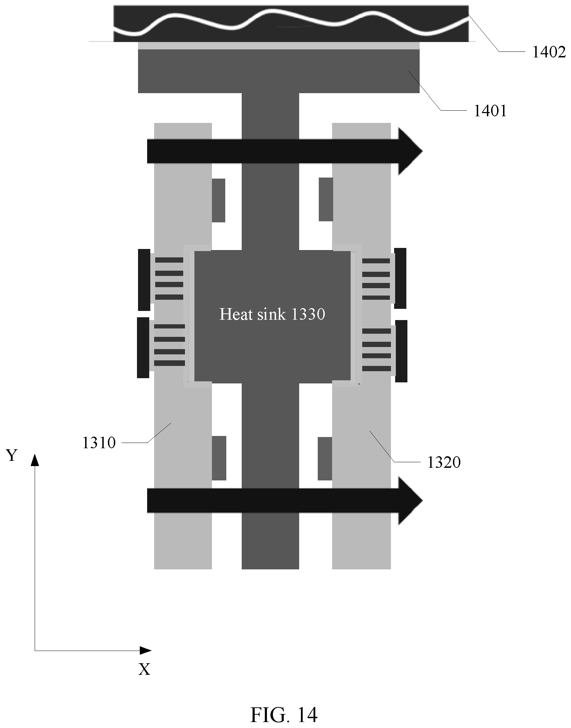

FIG. 14 is an example diagram of heat dissipation of the power module shown in FIG. 13. For descriptions of a specific structure of the power module shown in FIG. 14, refer to FIG. 13. Details are not described again. An end portion 1401 of the heat sink 1330 is connected to a cooling apparatus 1402. A position of the end portion 1401 of the heat sink 1330 is not limited in this embodiment, provided that the position of the end portion 1401 of the heat sink 1330 can avoid the first base plate 1310 and the second base plate 1320. It can be learned from FIG. 13 that the heat sink 1330 absorbs heat from the electronic components included in the power module, and the cooling apparatus 1402 can dissipate the heat absorbed by the heat sink 1330. A type of the cooling apparatus 1402 is not limited in this embodiment. For example, the cooling apparatus 1402 may dissipate heat through air cooling or liquid cooling. In this embodiment, an example in which the cooling apparatus 1402 dissipates heat through liquid cooling is used. In this case, the cooling apparatus 1402 includes a liquid cooling pipe. Liquid coolant flows in the liquid cooling pipe. The flowing liquid coolant can carry away the heat absorbed by the heat sink 1330, to achieve high-efficiency heat dissipation of the heat absorbed by the heat sink 1330.

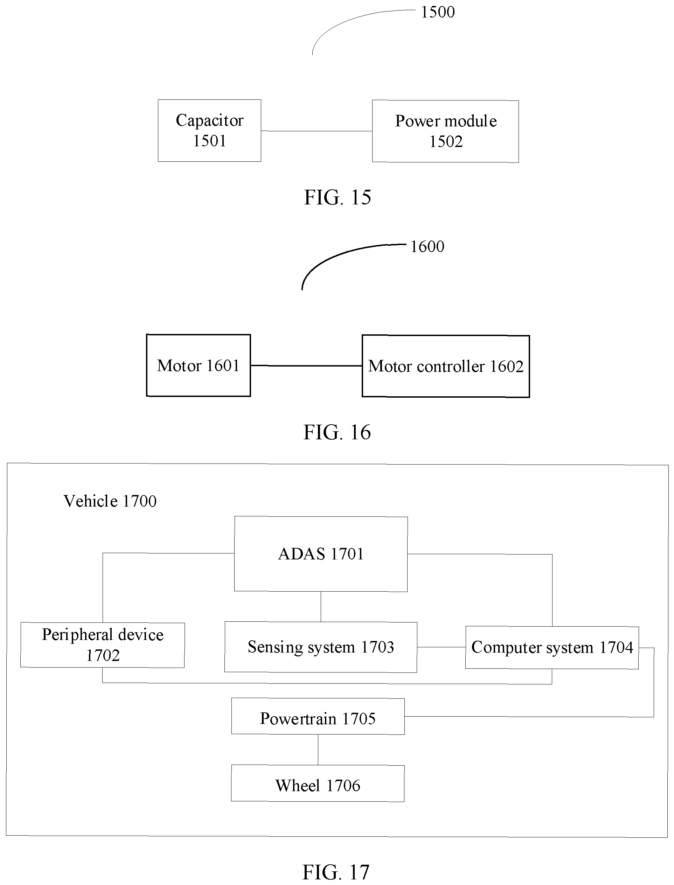

An embodiment of this application further provides a motor controller. FIG. 15 is an example diagram of a structure of an embodiment of the motor controller according to this application. The motor controller 1500 includes a capacitor 1501 and at least one power module 1502 described in any one of the foregoing embodiments. The power module 1502 is electrically connected to the capacitor 1501. The capacitor 1501 is configured to provide a voltage for the power module 1502. The motor controller 1500 is configured to convert a direct current output by a power battery pack to an alternating current. The alternating current is used to drive a motor.

The motor controller shown in this embodiment is used, thereby effectively improving heat dissipation efficiency of the power module 1502, and improving a service life of the motor controller.

An embodiment of this application further provides a powertrain. FIG. 16 is an example diagram of a structure of an embodiment of the powertrain according to this application. The powertrain 1600 includes a motor 1601 and a motor controller 1602 connected to the motor 1601. The motor controller 1602 is shown in the embodiment corresponding to FIG. 15. Details are not described again. The motor controller 1602 is configured to provide an alternating current for the motor 1601, and the motor 1601 is configured to convert the alternating current from the motor controller 1602 into kinetic energy.

An embodiment of this application further provides a vehicle. FIG. 17 is an example diagram of a structure of an embodiment of the vehicle according to this application. In this embodiment of this application, the vehicle may be an electric vehicle (electric vehicle, EV), a pure electric vehicle (pure electric vehicle, PEV) or (battery electric vehicle, BEV), a hybrid electric vehicle (hybrid electric vehicle, HEV), a range-extended electric vehicle (range-extended electric vehicle, REEV), a plug-in hybrid electric vehicle (plug-in hybrid electric vehicle, PHEV), a new energy vehicle (new energy vehicle), or the like.

In an embodiment, the vehicle 1700 is configured to be in a fully or partially autonomous driving mode. For example, the vehicle 1700 may control the vehicle when being in the autonomous driving mode, determine current statuses of the vehicle and an ambient environment of the vehicle through a manual operation, determine possible behavior of at least one another vehicle in the ambient environment, determine a confidence level corresponding to a possibility that the another vehicle performs the possible behavior, and control the vehicle 1700 based on determined information. When the vehicle 1700 is in the autonomous driving mode, the vehicle 1700 may be set to operate without interacting with a person. The vehicle 1700 may include various systems, and each system may include a plurality of elements. In addition, the systems and the elements of the vehicle 1700 may be interconnected in a wired or wireless manner.

The vehicle shown in this embodiment includes a sensor system 1703. The sensor system 1703 may include several sensors that sense information about the ambient environment of the vehicle 1700. For example, the sensor system 1703 may include a positioning system (the positioning system may be a global positioning system (global positioning system, GPS), may be a BeiDou system, or another positioning system), an inertial measurement unit (inertial measurement unit, IMU), a radar, a laser rangefinder, and a camera. The sensor system 1703 may further include a sensor (for example, an in-vehicle air quality monitor, a fuel gauge, or an oil thermometer gauge) of an internal system of the monitored vehicle 1700. Sensor data from one or more of these sensors may be used to detect an object and corresponding features (a position, a shape, a direction, a speed, and the like) of the object. Such detection and identification are key functions of safe operations of the autonomous vehicle 1700. The positioning system may be configured to estimate a geographic position of the vehicle 1700. The IMU is configured to sense position and orientation changes of the vehicle 1700 based on an inertial acceleration. In an embodiment, the IMU may be a combination of an accelerometer and a gyroscope. The radar may sense an object in the ambient environment of the vehicle 1700 by using a radio signal. In some embodiments, in addition to sensing the object, the radar may be further configured to sense a speed and/or a heading direction of the object. A specific type of the radar is not limited in this embodiment. For example, the radar may be a millimeter-wave radar or a lidar. The laser rangefinder may sense, by using a laser, an object in an environment in which the vehicle 1700 is located. In some embodiments, the laser rangefinder may include one or more laser sources, a laser scanner, one or more detectors, and another system component. The camera may be configured to capture a plurality of images of the ambient environment of the vehicle 1700. The camera may be a static camera, a video camera, a single/binocular camera, or an infrared imager.

The vehicle 1700 further includes an advanced driver assistance system (advanced driver assistance system, ADAS) 1701. The ADAS 1701 continuously senses the ambient environment during traveling of the vehicle, collects data, identifies static and dynamic objects, and performs systematic computation and analysis with reference to navigation map data. In this way, a driver perceives a potential risk in advance, thereby effectively improving driving comfort and safety of the vehicle. For example, the ADAS 1701 may control the vehicle by using data obtained by the sensing system 1703. For another example, the ADAS 1701 may control the vehicle by using head unit data. The head unit data may be main data (fuel consumption, an engine speed, a temperature, and the like) on a dashboard of the vehicle, vehicle speed information, steering wheel angle information, vehicle posture data, or the like.

The vehicle 1700 interacts with an external sensor, another vehicle, another computer system, or a user through a peripheral device 1702. The peripheral device 1702 may include a wireless communication system, an in-vehicle computer, a microphone and/or a speaker, and the like. In some embodiments, the peripheral device 1702 provides a means for the user of the vehicle 1700 to interact with a user interface. For example, the in-vehicle computer may provide information for the user of the vehicle 1700. The user interface may further operate the in-vehicle computer to receive an input from the user. The in-vehicle computer may perform an operation by using a touchscreen. In another case, the peripheral device 1702 may provide a means for the vehicle 1700 to communicate with another device located in the vehicle. For example, the microphone may receive audio (for example, a voice command or another audio input) from the user of the vehicle 1700. Similarly, the speaker may output audio to the user of the vehicle 1700.

The wireless communication system may wirelessly communicate with one or more devices directly or through a communication network. For example, the wireless communication system may use 3^{rd} generation (3^{rd} generation, 3G) mobile communication technology cellular communication, for example, code division multiple access (code division multiple access, CDMA), a global system for mobile communication (global system for mobile communication, GSM), or a general packet radio service (general packet radio service, GPRS). The wireless communication system may use 4^{th} generation mobile communication technology (4^{th} generation mobile communication technology, 4G) cellular communication, for example, long term evolution (long term evolution, LTE). The wireless communication system can alternatively use 5^{th} generation mobile communication technology (5^{th} generation mobile communication technology,5G) cellular communication, and 6^{th} generation mobile communication standard (6^{th} generation mobile networks, 6G). The wireless communication system may perform communication by using a wireless local area network (wireless local area network, WLAN). In some embodiments, the wireless communication system may directly communicate with a device through an infrared link, Bluetooth, or a ZigBee (ZigBee) protocol. The wireless communication system may further use various vehicle communication systems. For example, the wireless communication system may include one or more dedicated short-range communication (dedicated short-range communication, DSRC) devices. These devices may include public and/or private data communication between vehicles and/or roadside stations.

Some or all of functions of the vehicle 1700 are controlled by a computer system 1704. The computer system 1704 may control the functions of the vehicle 1700 based on inputs received from various systems (for example, the sensing system 1703, the ADAS 1701, and the peripheral device 1702) and the user interface. The computer system 1704 may include at least one processor. The processor executes instructions stored in a non-transient computer-readable medium such as a memory. The computer system 1704 may alternatively be a plurality of compute devices that control an individual component or a subsystem of the vehicle 1700 in a distributed manner.

A type of the processor is not limited in this embodiment. For example, the processor may be one or more field-programmable gate arrays (field-programmable gate arrays, FPGAs), an application-specific integrated circuit (application-specific integrated circuit, ASIC), a system on chip (system on chip, SoC), a central processing unit (central processing unit, CPU), a network processor (network processor, NP), a digital signal processing circuit (digital signal processor, DSP), a microcontroller unit (microcontroller unit, MCU), a programmable controller (programmable logic device, PLD), another integrated chip, or any combination of the foregoing chips or processors. The processor may be located inside the vehicle, or the processor may be located far away from the vehicle and wirelessly communicate with the vehicle.

In some embodiments, the memory may include instructions (for example, program logic). The instructions may be executed by the processor to perform various functions of the vehicle 1700. In addition to the instructions, the memory may store data, for example, map data, route information, a position, a direction, and a speed of the vehicle, and other vehicle data. Information stored in the memory may be used by the vehicle 1700 and the computer system 1704 during an operation of the vehicle 1700 in an autonomous, semi-autonomous, and/or manual mode.

The vehicle 1700 shown in this embodiment further includes a powertrain 1705 connected to the computer system 1704 and a wheel 1706 connected to the powertrain 1705. For descriptions of a structure of the powertrain 1705, refer to the embodiment corresponding to FIG. 16. Details are not described again. The powertrain 1705 is configured to provide power for the wheel 1706, and drive the wheel 1706 to perform movements such as moving forward, moving backward, or turning.

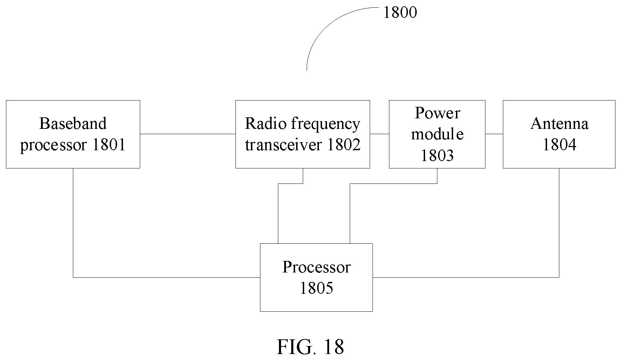

An embodiment of this application further provides a communication device. FIG. 18 is an example diagram of a structure of the communication device according to this application. For descriptions of a device type of the communication device 1800 shown in this embodiment, refer to the foregoing embodiment. Details are not described again. In this embodiment, an example in which the communication device 1800 is a base station is used. The communication device 1800 includes a baseband processor 1801, a radio frequency transceiver 1802, a power module 1803, and an antenna 1804 that are sequentially connected. The communication device 1800 further includes a processor 1805 that is connected to the baseband processor 1801, the radio frequency transceiver 1802, and the power module 1803. For descriptions of a structure of the power module 1803 shown in this embodiment, refer to any one of the foregoing embodiments. Details are not described again.

The communication device 1800 includes P transmitting channels and J receiving channels. P is any integer greater than or equal to 1, and J is any integer greater than or equal to 1. Each of the J receiving channels includes a receiver in the radio frequency transceiver 1802, a receiving module in the power module 1803, and a receiving antenna in the antenna 1804. Each of the P transmitting channels includes a transmitter in the radio frequency transceiver 1802, a transmitting module in the power module 1803, and a transmitting antenna in the antenna 1804. The transmitting channel includes at least one switch module. In the transmitting channel, the switch module may be connected between the transmitter and the transmitting module, and/or connected between the transmitting module and the transmitting antenna. The switch module is configured to turn on the transmitting channel or turn off the transmitting channel. The receiving channel includes at least one switch module. In the receiving channel, the switch module may be connected between the receiver and the receiving module, and/or connected between the receiving module and the receiving antenna. The switch module is configured to turn on or turn off the receiving channel. The processor 1805 included in the communication device 1800 shown in this example is configured to enable at least one of the P transmitting channels, and the processor 1805 is further configured to enable at least one of the J receiving channels.

When the processor 1805 enables the transmitting channel, the baseband processor 1801 sends a first digital signal to the transmitting channel. The transmitter in the radio frequency transceiver 1802 is configured to convert the first digital signal into a first radio frequency signal, and send the first radio frequency signal to the transmitting module in the power module 1803. The transmitting module processes the first radio frequency signal to obtain a processed first radio frequency signal. The transmitting module may include components a switch, a filter (filter), a power amplifier (power amplifier, PA), a low noise amplifier (low noise amplifier, LNA), an antenna tuner, or a phase shifter. For example, when the transmitting module includes a filter, processing of the first radio frequency signal by the filter refers to filtering the first radio frequency signal. For another example, when the transmitting module includes a PA, processing of the first radio frequency signal by the PA refers to amplifying power of the first radio frequency signal. The transmitting module sends the processed first radio frequency signal to the transmitting antenna. The transmitting antenna is configured to transmit the processed first radio frequency signal.

When the processor 1805 enables the receiving channel, the receiving antenna receives a second radio frequency signal. The receiving module in the power module 1803 processes the second radio frequency signal to obtain a processed second radio frequency signal, and sends the processed second radio frequency signal to the receiver in the radio frequency transceiver 1802. For descriptions of components included in the receiver and processing of the second radio frequency signal, refer to the descriptions of the components included in the transmitter and the processing of the first radio frequency signal. Details are not described. The receiver in the radio frequency transceiver 1802 is configured to convert the processed second radio frequency signal into a second digital signal, and sends the second digital signal to the baseband processor 1801. The baseband processor 1801 performs digital processing on the second digital signal.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising a first base plate, a first heat dissipation pad, and a first electronic component, wherein the first base plate comprises a first surface and a second surface that are opposite to each other, the first electronic component is connected to the first surface through the first heat dissipation pad, the second surface is recessed to form a first heat dissipation blind slot, the first heat dissipation pad has a first orthographic projection on the first surface, the first heat dissipation blind slot has a second orthographic projection on the first surface, and the first orthographic projection at least partially overlaps the second orthographic projection.

2. The power module according to claim 1, wherein the first heat dissipation blind slot has an accommodation cavity, and a cavity wall of the accommodation cavity comprises a metal layer.

3. The power module according to claim 1 or 2, wherein the power module further comprises a thermally conductive module, the thermally conductive module is made of a thermally conductive material, the thermally conductive module is located in the accommodation cavity of the first heat dissipation blind slot, and the thermally conductive module is connected to the accommodation cavity.

4. The power module according to claim 2 or 3, wherein the first base plate and the first electronic component are located inside a housing of the power module, the power module further comprises a heat dissipation layer, the heat dissipation layer is located between the thermally conductive module and the housing, one surface of the heat dissipation layer is in contact with the thermally conductive module, and the other surface of the heat dissipation layer is in contact with the housing.

5. The power module according to any one of claims 1 to 4, wherein the first base plate comprises a first region, the first region is located between the first heat dissipation pad and a slot bottom of the first heat dissipation blind slot, a plurality of vias penetrating the first region are provided, two ends of the via have a first hole opening and a second hole opening, the first hole opening extends to the first heat dissipation pad, and the second hole opening extends to the slot bottom of the first heat dissipation blind slot.

6. The power module according to any one of claims 1 to 5, wherein the power module further comprises a second heat dissipation pad and a second electronic component, the second electronic component is connected to the first surface through the second heat dissipation pad, the second heat dissipation pad has a third orthographic projection on the first surface, the first orthographic projection and the third orthographic projection are isolated from each other, and the second orthographic projection at least partially overlaps the third orthographic projection.

7. The power module according to any one of claims 1 to 5, wherein the power module further comprises a second heat dissipation pad and a second electronic component, the second electronic component is connected to the first surface through the second heat dissipation pad, the second surface is further recessed to form a second heat dissipation blind slot, and an orthographic projection of the second heat dissipation pad onto the first surface at least partially overlaps an orthographic projection of the second heat dissipation blind slot onto the first surface.

8. The power module according to any one of claims 1 to 7, wherein the power module further comprises a second base plate, a third heat dissipation pad, and a third electronic component, the third electronic component is connected to a first surface of the second base plate through the third heat dissipation pad, a second surface of the second base plate is recessed to form a third heat dissipation blind slot, and an orthographic projection of the third heat dissipation pad onto the first surface of the second base plate at least partially overlaps an orthographic projection of the third heat dissipation blind slot onto the first surface of the second base plate; and
the power module further comprises a heat sink, the heat sink is located between the second surface of the first base plate and the second surface of the second base plate, a first boss of the heat sink is inserted into the first heat dissipation blind slot, and a second boss of the heat sink is inserted into the third heat dissipation blind slot.

9. The power module according to claim 8, wherein the first boss is in contact with a slot wall of the first heat dissipation blind slot, the second boss is in contact with a slot wall of the third heat dissipation blind slot, an extension direction of the slot wall of the first heat dissipation blind slot intersects the first surface of the first base plate, and an extension direction of the slot wall of the third heat dissipation blind slot intersects the first surface of the second base plate.

10. The power module according to claim 9, wherein the power module further comprises a first thermally conductive layer and a second thermally conductive layer, the first thermally conductive layer is located between the slot bottom of the first heat dissipation blind slot and the first boss, and the second thermally conductive layer is located between a slot bottom of the third heat dissipation blind slot and the second boss.

11. A communication device, comprising a baseband processor, a radio frequency transceiver, a power module, and an antenna that are sequentially connected, and the power module according to any one of claims 1 to 10, wherein
the communication device comprises P transmitting channels and J receiving channels, P and J each are any integers greater than or equal to 1, each of the J receiving channels comprises a receiver in the radio frequency transceiver, a receiving module in the power module, and a receiving antenna in the antenna, and each of the P transmitting channels comprises a transmitter in the radio frequency transceiver, a transmitting module in the power module, and a transmitting antenna in the antenna.

12. A motor controller, comprising a capacitor and at least one power module according to any one of claims 1 to 10, wherein the power module is electrically connected to the capacitor, the capacitor is configured to provide a voltage for the power module, the power module is configured to convert a direct current into an alternating current, and the alternating current is used to drive a motor.

13. A powertrain, comprising a motor and the motor controller according to claim 12 connected to the motor, wherein the motor controller is configured to provide an alternating current for the motor, and the motor is configured to convert the alternating current from the motor controller into kinetic energy.

14. A vehicle, comprising a wheel and the powertrain according to claim 13 connected to the wheel, wherein the powertrain is configured to provide power for the wheel and drive the wheel to move.
